# EUROPEAN PATENT APPLICATION

(11) **EP 3 096 349 A1**
(43) Date of publication of application: **23.11.2016**
(21) Application number: 16164590.8
(22) Date of filing: 10.04.2016
(51) Int. Cl.: H01L 21/60, H01L 23/485, H01L 25/10, H01L 23/538, H01L 23/31

(54) **SEMICONDUCTOR PACKAGE ASSEMBLY AND METHOD FOR FORMING THE SAME**

(30) Priority: 21.05.2015 US 201562164725 P; 16.03.2016 US 201615071559
(71) Applicant: MediaTek Inc., Hsin-Chu 300 (TW)
(72) Inventor: LIN, Tzu-Hung, Zhubei City, Hsinchu County 302 (TW); HSIAO, Ching-Wen, Hsinchu City 300 (TW); PENG, I-Hsuan, Hsinchu City 300 (TW)
(74) Representative: Goddar, Heinz J.

(57) **Abstract**

A semiconductor package assembly is provided. The semiconductor package assembly includes a first semiconductor package. The first semiconductor package includes a first semiconductor die. A first redistribution layer (RDL) structure is coupled to the first semiconductor die. The semiconductor package assembly also includes a second semiconductor package bonded to the first semiconductor package. The second semiconductor package includes a second semiconductor die. An active surface of the second semiconductor die faces an active surface of the first semiconductor die. A second RDL structure is coupled to the second semiconductor die. The first RDL structure is positioned between the first semiconductor die and the second RDL structure.

## Description

### Cross reference to related AppLlcations

This Application is based on, and claims the benefit of U.S. Provisional Application No. 62/164,725 filed on May 21, 2015, the entirety of which is incorporated by reference herein.

### BACKGROUND of the invention

### Field of the Invention

The present invention relates to a semiconductor package assembly, and in particular to a three-dimensional (3D) semiconductor package assembly and methods for forming the same.

### Description of the Related Art

The semiconductor industry has experienced continuous and rapid growth due to the desire for miniaturization and multi-functionality of electronic products. Integration density has been improved to allow more chips or dies to be integrated into a semiconductor package, such as a two-dimensional (2D) semiconductor package. However, there are physical limitations to 2D semiconductor packages. For example, when more than two dies with various functions are put into a 2D semiconductor device, it becomes more difficult to develop the more complex designs and layouts that are required.

Although 3D integrated circuits and stacked dies have been developed and are commonly used, the dies integrated into a conventional 3D semiconductor package are limited to be the same size. Furthermore, 3D semiconductor packaging technology suffers from various problems that may cause a reduction of the manufacturing yield.

Thus, there exists a need to develop a semiconductor package assembly, and methods for forming the same, capable of mitigating or eliminating the aforementioned problems.

### Brief Summary of THE Invention

A semiconductor package assembly and a method for forming a semiconductor package assembly are provided.

According to one aspect, the invention provides a semiconductor package assembly, comprising: a first semiconductor package, comprising: a first semiconductor die; and a first redistribution layer (RDL) structure coupled to the first semiconductor die; and a second semiconductor package bonded to the first semiconductor package, wherein the second semiconductor package comprises: a second semiconductor die, wherein an active surface of the second semiconductor die faces an active surface of the first semiconductor die; and a second RDL structure coupled to the second semiconductor die. The semiconductor package may include one or more of the following features in any combination thereof.

The first semiconductor package may comprise more than one first semiconductor die or the second semiconductor package comprises more than one second semiconductor die.

The semiconductor package assembly further may comprise a conductive structure, wherein the conductive structure is coupled to the first RDL structure and the second RDL structure.

The semiconductor package assembly further may comprise an adhesive layer, wherein the adhesive layer is positioned between the first RDL structure and the second RDL structure and surrounds the conductive structure.

The first semiconductor die and the second semiconductor die may be of different sizes.

The first semiconductor package further may comprise a first molding compound, wherein the first molding compound surrounds sidewalls of the first semiconductor die.

The first RDL structure may cover the first molding compound.

The first semiconductor package further may comprise a via, wherein the via penetrates the first molding compound and is coupled to the first RDL structure.

The semiconductor package assembly further may comprise a conductive component coupled to the via, wherein the first semiconductor die is positioned between the first RDL structure and the conductive component.

The second semiconductor package further may comprise a second molding compound, and the second molding compound surrounds sidewalls of the second semiconductor die.

The second RDL structure may cover the second molding compound.

The second semiconductor package may further comprise a via, wherein the via penetrates the second molding compound and is coupled to the second RDL structure.

The semiconductor package assembly further may comprise a conductive component coupled to the via, wherein the second semiconductor die is positioned between the second RDL structure and the conductive component.

According to a further aspect, the invention provides a semiconductor package assembly, comprising: a first package, comprising: a first component; and a first redistribution layer (RDL) structure coupled to the first component; and a second package bonded to the first package, wherein the second package comprises: a second component; and a second RDL structure coupled to the second component, wherein the first RDL structure is positioned between the first component and the second RDL structure. The semiconductor package may include one or more of the following features in any combination thereof.

The first component and the second component may be of different sizes.

One of the first and second components may be an active device, and another one of the first and second components may be a passive device.

The first package may comprise more than one first component or the second package comprises more than one second component.

The first package may comprise more than one first component and the second package may comprise more than one second component, and wherein at least one of the first components and one of the second components are of different sizes.

The semiconductor package assembly may further comprise a first molding compound and a second molding compound, wherein the first molding compound surrounds sidewalls of the first component and the second molding compound surrounds sidewalls of the second component.

The semiconductor package assembly may further comprise a via, wherein the via penetrates the first or second molding compound.

The semiconductor package assembly may further comprise a conductive component coupled to the via.

According to a further aspect, the invention provides a method for forming a semiconductor package assembly, comprising: forming a first semiconductor package, wherein the first semiconductor package comprises: a first semiconductor die; and a first redistribution layer (RDL) structure coupled to the first semiconductor die; forming a second semiconductor package, wherein the second semiconductor package comprises: a second semiconductor die, wherein an active surface of the second semiconductor die faces an active surface of the first semiconductor die; and a second RDL structure coupled to the second semiconductor die: and bonding the second semiconductor package to the first semiconductor package, wherein the first RDL structure is positioned between the first semiconductor die and the second RDL structure. The method may include one or more of the following features in any combination thereof.

The second semiconductor package may be bonded to the first semiconductor package through an adhesive.

The method may further comprise forming a conductive structure to electrically connect the first semiconductor die and the second semiconductor die.

The formation of the second semiconductor package may comprise: forming vias on a second carrier substrate; bonding the second semiconductor die onto the second carrier substrate; forming a second molding compound on the second carrier substrate, wherein the second molding compound surrounds the vias and sidewalls of the second semiconductor die, and wherein the second molding compound exposes top surfaces of the vias and the second semiconductor die; and forming the second RDL structure on the second semiconductor die and the second molding compound.

The method may further comprise removing the second carrier substrate after bonding the second semiconductor package to the first semiconductor package.

The method may further comprise forming a conductive component on the second semiconductor package after removing the second carrier substrate.

The formation of the first semiconductor package may comprise: bonding the first semiconductor die onto a first carrier substrate; forming a first molding compound on the first carrier substrate, wherein the first molding compound surrounds sidewalls of the first semiconductor die and exposes a top surface of the first semiconductor die; and forming the first RDL structure on the first semiconductor die and the first molding compound.

The method may further comprise: removing the first carrier substrate after bonding the second semiconductor package to the first semiconductor package; and performing a singulation process to the first semiconductor package and the second semiconductor package.

The formation of the first semiconductor package may comprise bonding more than one first semiconductor die onto the first carrier substrate, wherein the first molding compound further surrounds sidewalls of the first semiconductor dies and exposes a top surface of the first semiconductor dies.

A detailed description is given in the following embodiments with reference to the accompanying drawings.

### BRIEF DESCRIPTION OF the DRAWINGS

The present invention can be more fully understood by reading the subsequent detailed description and examples with references made to the accompanying drawings, wherein:
FIGS. 1A-1C are cross-sectional views of various stages of a method for forming a semiconductor package, in accordance with some embodiments of the disclosure.
FIGS. 2A-2C are cross-sectional views of various stages of a method for forming a semiconductor package, in accordance with some embodiments of the disclosure.
FIGS. 3A-3E are cross-sectional views of various stages of a method for forming a semiconductor package assembly, in accordance with some embodiments of the disclosure.
FIG. 4 is a cross-sectional view of a semiconductor package assembly, in accordance with some embodiments of the disclosure.
FIG. 5 is a cross-sectional view of a semiconductor package assembly, in accordance with some embodiments of the disclosure.

### Detailed Description of the Invention

The following description is of the best-contemplated mode of carrying out the invention. This description is made for the purpose of illustrating the general principles of the invention and should not be taken in a limiting sense. The scope of the invention is determined by reference to the appended claims.

The present invention will be described with respect to particular embodiments and with reference to certain drawings, but the invention is not limited thereto and is only limited by the claims. The drawings described are only schematic and are non-limiting. In the drawings, the size of some of the elements may be exaggerated for illustrative purposes and not drawn to scale. The dimensions and the relative dimensions do not correspond to actual dimensions in the practice of the invention.

Embodiments of the disclosure provide a 3D system-in-package (SIP) semiconductor package assembly. The semiconductor package assembly is integrated with more than two components or dies so that the size of electronic products made using the semiconductor package assembly can be reduced. These components or dies are separately fabricated and are subsequently integrated into the semiconductor package assembly. As a result, their sizes and/or functions are not limited to be the same. The design flexibility of the semiconductor package assembly is greatly improved. Furthermore, these components or dies are tested in advance to make sure that the semiconductor package assembly only includes good components or dies. As a result, the yield loss resulted from multiple defective components or dies is significantly mitigated or eliminated. Therefore, the manufacturing cost of the semiconductor package assembly is reduced.

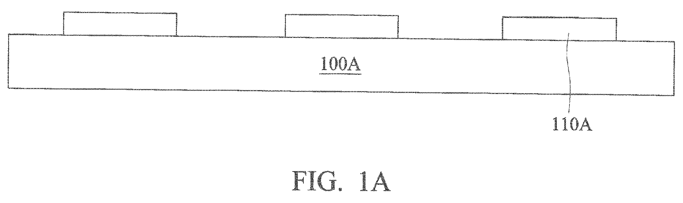

FIGS. 1A-1C are cross-sectional views of various stages of a method for forming a semiconductor package, in accordance with some embodiments of the disclosure. Additional operations can be provided before, during, and/or after the stages described in FIGS. 1A-1C. Some of the stages that are described can be replaced or eliminated for different embodiments. Additional features can be added to the semiconductor package. Some of the features described below can be replaced or eliminated for different embodiments.

As shown in FIG. 1A, a first carrier substrate 100A is provided. In some embodiments, the first carrier substrate 100A is a wafer or a panel. The first carrier substrate 100A may include glass or another suitable supporting material.

As shown in FIG. 1A, multiple first components 110A are bonded onto the first carrier substrate 100A. In accordance with some embodiments of the disclosure, the first components 110A are known-good components. In other words, no defective components are bonded onto the first carrier substrate 100A. In some embodiments, the first components 110A and the first carrier substrate 100A are attached together through an adhesive layer such as glue or another suitable adhesive material.

In some embodiments, the first components 110A are active devices and can be referred to as first semiconductor dies (or chips) 110A. The first semiconductor dies 110A may include transistors or another suitable active element. For example, the first semiconductor dies 110A may be a logic die including a central processing unit (CPU), a graphics processing unit (GPU), a dynamic random access memory (DRAM) controller or any combination thereof. In some other embodiments, the first components 110A are passive devices such as integrated passive devices (IPDs). The first components 110A may include capacitors, resistors, inductors, varactor diodes or another suitable passive element.

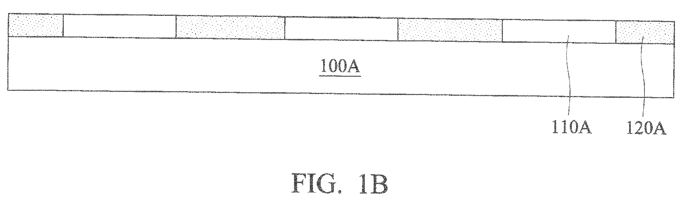

As shown in FIG. 1B, a first molding compound 120A is formed on the first carrier substrate 100A. The first molding compound 120A surrounds the sidewalls of the first components 110A without covering the top and bottom surfaces of the first components 110A.

In some embodiments, the first molding compound 120A is formed of a nonconductive material such as an epoxy, a resin, a moldable polymer, or another suitable molding material. In some embodiments, the first molding compound 120A is applied as a substantial liquid, and then is cured through a chemical reaction. In some other embodiments, the first molding compound 120A is an ultraviolet (UV) or thermally cured polymer applied as a gel or malleable solid, and then is cured through a UV or thermal curing process. The first molding compound 120A may be cured with a mold.

In some embodiments, the deposited first molding compound 120A covers the top surfaces of the first components 110A, and then a grinding process is performed to thin the deposited first molding compound 120A. As a result, the thinned first molding compound 120A exposes the top surfaces of the first components 110A. In some embodiments, the top and bottom surfaces of the first molding compound 120A are coplanar with the top and bottom surfaces of the first components 110A, respectively.

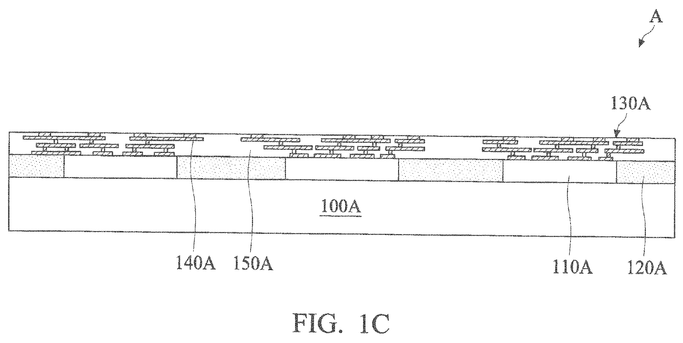

As shown in FIG. 1C, a first redistribution layer (RDL) structure 130A, which is also referred to as a fan-out structure, is formed on the first molding compound 120A and is coupled to the first components 110A. As a result, a first (semiconductor) package A is formed. In some embodiments, the first (semiconductor) package A is a wafer-level fan-out package.

The first RDL structure 130A covers the first molding compound 120A and may be in direct contact with the first molding compound 120A. In some embodiments, the first RDL structure 130A includes one or more conductive traces 140A disposed in and surrounded by an inter-metal dielectric (IMD) layer 150A. The first components 110A are electrically connected to the conductive traces 140A of the first RDL structure 130A. The IMD layer 150A may include multiple sub-dielectric layers successively stacked on the first molding compound 120A and the first components 110A. For example, a first layer-level of the conductive traces 140A is positioned on a first layer-level of the sub-dielectric layers and covered by a second layer-level of the sub-dielectric layers. A second layer-level of the conductive traces 140A is positioned on the second layer-level of the sub-dielectric layers and covered by a third layer-level of the sub-dielectric layers.

In some embodiments, the IMD layer 150A may be formed of organic materials, which include a polymer base material, non-organic materials, which include silicon nitride (SiN_{X}), silicon oxide (SiO_{X}), graphene, or the like. In some embodiments, the IMD layer 150A is a high-k dielectric layer (k is the dielectric constant of the dielectric layer). In some other embodiments, the IMD layer 150A may be formed of a photosensitive material, which includes a dry film photoresist, or a taping film.

Pad portions of the conductive traces 140A are exposed from the top surface of the first RDL structure 130A. For example, the pad portions of the conductive traces 140A are exposed from openings of the IMD layer 150A and connected to subsequently formed conductive components. It should be noted that the number and configuration of the conductive trace 140A and the IMD layer 150A shown in figures are only examples and are not limitations to the present invention.

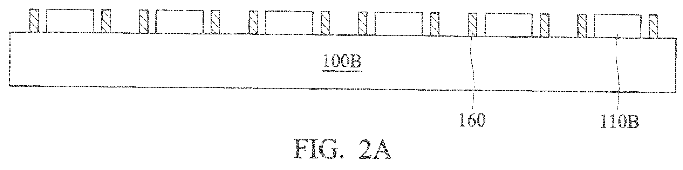

FIGS. 2A-2C are cross-sectional views of various stages of a method for forming a semiconductor package, in accordance with some embodiments of the disclosure. Additional operations can be provided before, during, and/or after the stages described in FIGS. 2A-2C. Some of the stages that are described can be replaced or eliminated for different embodiments. Additional features can be added to the semiconductor package. Some of the features described below can be replaced or eliminated for different embodiments.

As shown in FIG. 2A, a second carrier substrate 100B is provided. In some embodiments, the second carrier substrate 100B is a wafer or a panel. The second carrier substrate 100B may include glass, or another suitable supporting material.

As shown in FIG. 2A, multiple vias 160 are formed on the second carrier substrate 100B. The vias 160 may be through interposer vias (TIV). In some embodiments, the vias 160 are copper pillars or other suitable conductive structures. In some embodiments, the vias 160 are formed by an electroplating process or another suitable process.

As shown in FIG. 2A, multiple second components 110B are bonded onto the second carrier substrate 100B. In accordance with some embodiments of the disclosure, the second components 110B are known-good components. In other words, no defective components are bonded onto the second carrier substrate 100B. In some embodiments, the second components 110B and the second carrier substrate 100B are attached together through an adhesive layer such as glue or another suitable adhesive material. In some embodiments, each of the second components 110B is positioned between two of the vias 160. In some embodiments, one or more vias 160 are positioned between two of the second components 110B.

In some embodiments, the second components 110B are active devices and can be referred to as second semiconductor dies (or chips) 110B. The second semiconductor dies 110B may include transistors or other suitable active elements. For example, the second semiconductor dies 110B may be a logic die including a CPU, a GPU, a DRAM controller or any combination thereof. In some other embodiments, the second components 110B are passive devices such as IPDs. The second components 110B may include capacitors, resistors, inductors, varactor diodes, and other suitable passive elements.

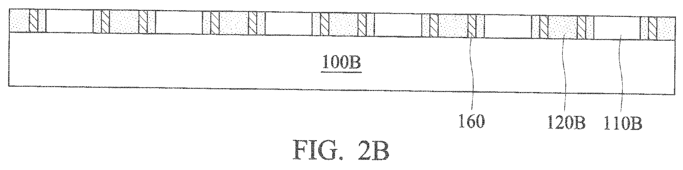

As shown in FIG. 2B, a second molding compound 120B is formed on the second carrier substrate 100B. The second molding compound 120B surrounds the vias 160 and the sidewalls of the second components 110B without covering the top and bottom surfaces of the second components 110B and the vias 160. Namely, the vias 160 penetrate or pass through the second molding compound 120B.

In some embodiments, the second molding compound 1208 is formed of a nonconductive material such as an epoxy, a resin, a moldable polymer, or another suitable molding material. In some embodiments, the second molding compound 120B is applied as a substantial liquid, and then is cured through a chemical reaction. In some other embodiments, the second molding compound 120B is an UV or thermally cured polymer applied as a gel or malleable solid, and then is cured through a UV or thermal curing process. The second molding compound 120B may be cured with a mold.

In some embodiments, the deposited second molding compound 120B covers the top surfaces of the second components 110B and the vias 160, and then a grinding process is performed to thin the deposited second molding compound 120B. As a result, the thinned second molding compound 120B exposes the top surfaces of the second components 110B and the vias 160. In some embodiments, the top and bottom surfaces of the second molding compound 120B are coplanar with the top and bottom surfaces of the second components 110B, respectively. In some embodiments, the top and bottom surfaces of the second molding compound 120B are coplanar with the top and bottom surfaces of the vias 160, respectively.

In accordance with some embodiments of the disclosure, the second components 110B are previously thinned before being bonded onto the second carrier substrate 100B. As a result, the second components 110B and the vias 160 substantially have the same thickness and thereby facilitating the exposure of the second components 110B and the vias 160. For example, a semiconductor wafer is thinned and is subsequently diced into semiconductor dies (or chips) to form the second components 110B. The second components 110B may be thinned by a mechanical grinding process, a chemical mechanical polishing process, a milling process or another suitable process.

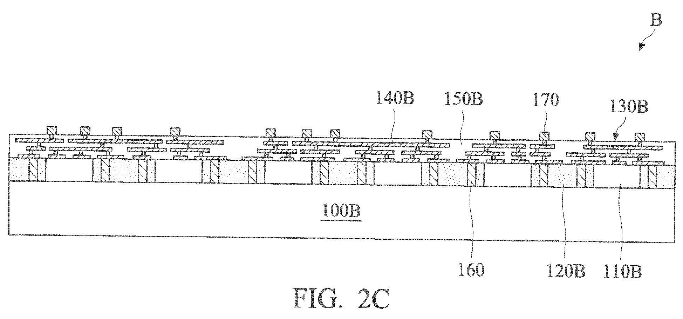

As shown in FIG. 2C, a second RDL structure 130B is formed on the second molding compound 120B and is coupled to the second components 110B and the vias 160. The second RDL structure 130B covers the second molding compound 120B and may be in direct contact with the second molding compound 120B. In some embodiments, the second RDL structure 130B includes one or more conductive traces 140B disposed in and surrounded by an IMD layer 150B. The second components 110B are electrically connected to the conductive traces 140B of the second RDL structure 130B. Pad portions of the conductive traces 140B are exposed from the top surface of the second RDL structure 130B. The structure of the second RDL structure 130B may be similar to or the same as the structure of the first RDI. structure 130A, as aforementioned in detail. It should be noted that the number and configuration of the conductive trace 140B and the IMD layer 150B shown in figures are only examples and are not limitations to the present invention.

As shown in FIG. 2C, multiple conductive structures 170 are formed on the second RDL structure 130B. The conductive structures 170 are electrically connected to the pad portions of the conductive traces 140B. As a result, a second (semiconductor) package B is formed. In some embodiments, the second (semiconductor) package B is a wafer-level fan-out package.

In some embodiments, the conductive structures 170 are conductive pillars, conductive bumps (such as micro bumps), conductive paste structures, or another suitable conductive structure. The conductive structures 170 may include copper, solder, or another suitable conductive material. For example, the conductive structures 170 may be copper pillars covered with a solder layer.

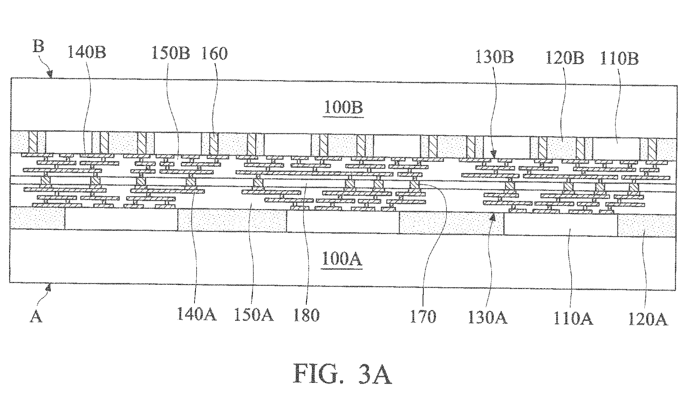

FIGS. 3A-3E are cross-sectional views of various stages of a method for forming a semiconductor package assembly, in accordance with some embodiments of the disclosure. Additional operations can be provided before, during, and/or after the stages described in FIGS. 3A-3E. Some of the stages that are described can be replaced or eliminated for different embodiments. Additional features can be added to the semiconductor package assembly. Some of the features described below can be replaced or eliminated for different embodiments.

As shown in FIG. 3A, the second package B is bonded to the first package A so that the first RDL structure 130A is positioned between the first components 110A and the second RDL structure 130B. The conductive structures 170 are positioned between the first RDL structure 130A and the second RDL structure 130B and are coupled thereto. The conductive traces 140A of the first RDL structure 130A are electrically connected to the conductive traces 140B of the second RDL structure 130B through the conductive structures 170. For example, the conductive structures 170 are in direct contact with the pad portions of the conductive traces 140A and 140B. In some embodiments, an active surface of the first component 110A faces an active surface of the second component 110B.

In accordance with some embodiments of the disclosure, the first package A and the second package B are bonded together through an adhesive layer 180. The adhesive layer 180 fills a space between the first RDL structure 130A and the second RDL structure 130B. In some embodiments, the adhesive layer 180 surrounds the conductive structures 170. In some embodiments, the adhesive layer 180 is formed of epoxy, butyl cyclobutane (BCB), epoxy chloropropane (ECP), or another suitable adhesive material.

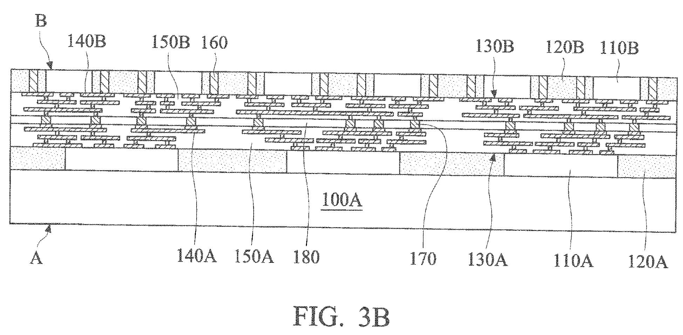

As shown in FIG. 3B, the second carrier substrate 100B is removed from the second package B. As a result, the second components 110B and the vias 160 are exposed. The sidewalls of the second components 110B and the vias 160 are still surrounded by the second molding compound 120B. In some embodiments, the adhesive property of the adhesive layer, which is used to bond the second components 110B and the second carrier substrate 100B, is eliminated to debond the second carrier substrate 100B.

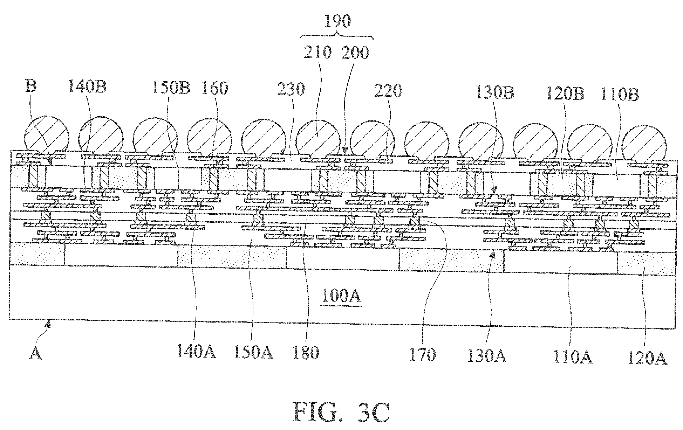

As shown in FIG. 3C, a conductive component 190 is formed on the second package B away from the first package A. In other words, the conductive component 190 and the first package A are positioned on two opposite sides of the second package B. The second components 110B are positioned between the second RDL structure 130B and the conductive component 190.

In some embodiments, the conductive component 190 is electrically connected or coupled to the second components 110B through the vias 160 and the second RDL structure 130B. In some embodiments, the conductive component 190 is further electrically connected to the first components 110A through the vias 160, the second RDL structure 130B, the conductive structures 170 and the first RDL structure 130A.

In some embodiments, the conductive component 190 is formed of a RDL structure 200 and conductive structures 210 over the RDL structure 200. In some embodiments, the RDL structure 200 includes one or more conductive traces 220 disposed in and surrounded by an IMD layer 230. Pad portions of the conductive traces 220 are exposed from the top surface of the RDL structure 200. The structure of the RDL structure 200 may be similar to or the same as the structure of the first RDL structure 130A, as aforementioned in detail.

The conductive structures 210 are electrically connected to the exposed pad portions of the conductive traces 220. The vias 160 are electrically connected or coupled to the conductive structures 210 through the conductive traces 220. In some embodiments, the conductive structures 210 are bonding balls (such as solder balls), or another suitable conductive structures. It should be noted that the number and configuration of the conductive structures 210 and the conductive traces 220 shown in figures are only examples and are not limitations to the present invention.

In some other embodiments, the conductive component 190 is formed of the conductive structures 210. The vias 160 are directly electrically connected to the conductive structures 210. The vias 160 may be electrically connected to the conductive structures 210 through one or more conductive layers.

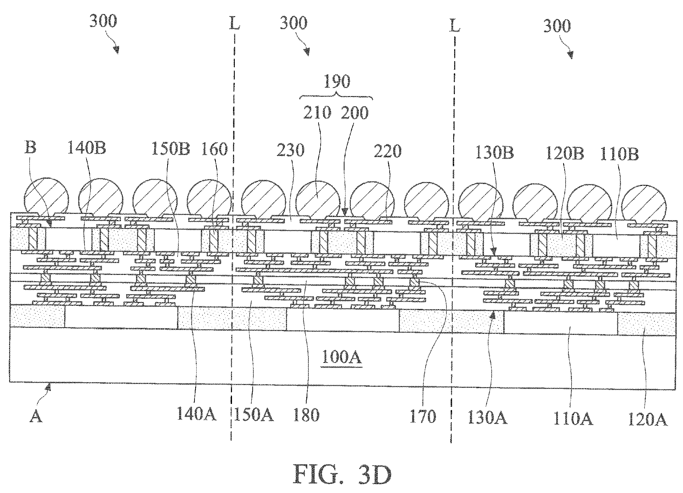

As shown in FIG. 3D, the first carrier substrate 100A is removed from the first package A. As a result, the first components 110A are exposed. The sidewalls of the first components 110A are still surrounded by the first molding compound 120A. In some embodiments, the adhesive property of the adhesive layer, which is used to bond the first components 110A and the first carrier substrate 100A, is eliminated to debond the first carrier substrate 100A.

Afterwards, a singulation process is performed on the bonded packages A and B. The bonded packages A and B are cut or diced along scribe lines L to separate the bonded packages A and B into multiple semiconductor package assemblies 300. The semiconductor package assemblies 300 are SIP semiconductor package assemblies and wafer-level fan-out packages are integrated in the semiconductor package assemblies 300.

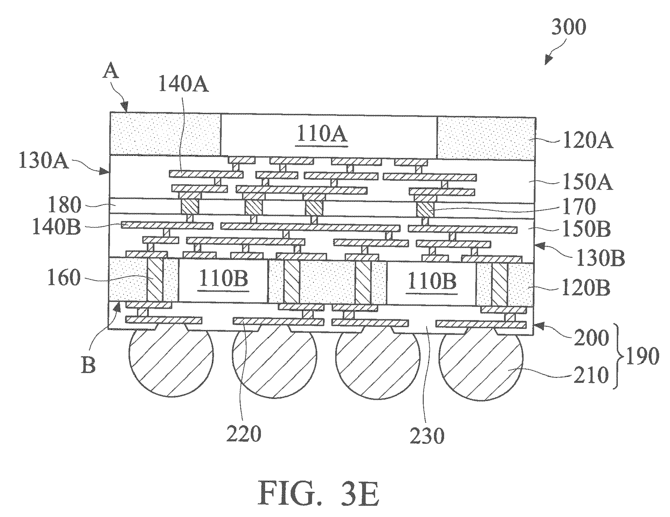

As shown in FIG. 3E, each of the semiconductor package assemblies 300 includes one first component 110A and two second components 110B. The semiconductor package assembly 300 may include more than two second components 110B. In some embodiments, the size of the first component 110A is different from that of the second components 110B. For example, the size of the first component 110A is greater than that of the second components 110B. In some embodiments, the second components 110B are the same size. In some other embodiments, the second components 110B are different sizes.

In some embodiments, the first component 110A and the second components 110B have the same function. Therefore, the semiconductor package assembly 300 is homogeneous integration. In some other embodiments, the function of the first component 110A is different from the function of one or more of the second components 110B. Therefore, the semiconductor package assembly 300 is heterogeneous integration.

In some embodiments, one of the first component 110A and the second components 110B is a system-on-chip (SOC) and another of the first component 110A and the second components 110B is a DRAM. In some embodiments, one of the first component 110A and the second components 110B is an analog processor (AP) and another of the first component 110A and the second components 110B is a digital processor (DP). In some embodiments, one of the first component 110A and the second components 10B is a baseband (BB) component and another of the first component 110A and the second components 110B is a radio-frequency (RF) component.

For example, in some embodiments, the first component 110A is an active device while the second components 110B are passive devices with the same or different functions. In some embodiments, the first component 110A and one of the second components 110B are active devices with the same or different functions while another second component 110B is a passive device. In some other embodiments, the first component 10A and the second components 110B are active devices with various different functions.

Alternatively, in some embodiments, the first component 110A is a passive device while the second components 110B are active devices with the same or different functions. In some embodiments, the first component 110A and one of the second components 110B are passive devices with the same or different functions while another second component 110B is an active device.

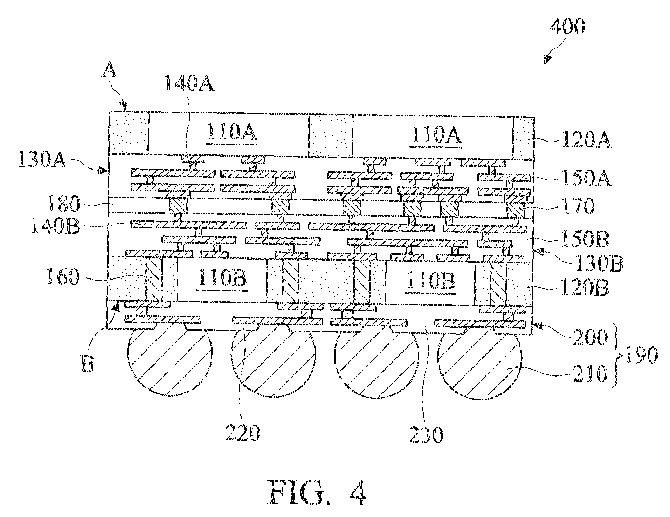

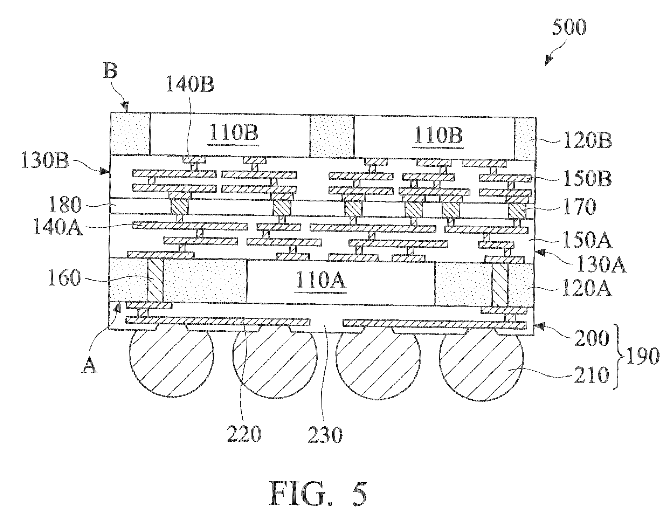

Many variations and/or modifications can be made to embodiments of the disclosure. FIGS. 4 and 5 are cross-sectional views of a semiconductor package assembly, in accordance with some embodiments of the disclosure. Elements in FIGS. 4 and 5 that are the same as those in FIG. 3E are labeled with the same reference numbers as in FIG. 3E and are not described again for brevity.

Referring to FIG. 4, a semiconductor package assembly 400 is shown. The semiconductor package assembly 400 is similar to the semiconductor package assembly 300 shown in FIG. 3E. The main difference between the semiconductor package assemblies 300 and 400 is that the semiconductor package assembly 300 includes one first component 110A while the semiconductor package assembly 400 includes two first components 110A. The semiconductor package assembly 400 may include more than two first components 110A.

In some embodiments, the first components 110A are the same size. In some other embodiments, the first components 110A are different sizes. In some embodiments, the size of the first components 110A is different from that of the second components 110B. For example, the size of the first components 110A is greater than that of the second components 110B. In some embodiments, the first components 110A have the same function. In some other embodiments, the first components 110A have the different functions.

Referring to FIG. 5, a semiconductor package assembly 500 is shown. The semi-conductor package assembly 500 is similar to the semiconductor package assembly 300 shown in FIG. 3F. The main difference between the semiconductor package assemblies 300 and 500 is that the vias 160 of the semiconductor package assembly 300 are formed in the second package B while the vias 160 of the semiconductor package assembly 500 are formed in the first package A. As a result, the conductive component 190 of the semiconductor package assembly 300 is formed on the second package B while the conductive component 190 of the semiconductor package assembly 500 is formed on the first package A.

In FIG. 5, the vias 160 penetrate the first molding compound 120A and are electrically connected or coupled to the first RDL structure 130A. The conductive component 190 and the second package B are positioned on two opposite sides of the first package A. The first components 110A are positioned between the first RDL structure 130A and the conductive component 190.

The semiconductor package assembly and methods for forming the same in accordance with some embodiments of the disclosure provide various advantages. According to the aforementioned embodiments, more than two components or dies can be integrated in a semiconductor package assembly. These components or dies are fabricated in different processes and are known-good components or dies. Therefore, sizes and/or functions of the components or dies are not limited, thereby facilitating improvements to the flexibility of the design. The manufacturing yield of the semiconductor package assembly is significantly enhanced even further.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A semiconductor package assembly, comprising:
a first semiconductor package, comprising:
a first semiconductor die; and
a first redistribution layer (RDL) structure coupled to the first semiconductor die; and
a second semiconductor package bonded to the first semiconductor package, wherein the second semiconductor package comprises:
a second semiconductor die, wherein an active surface of the second semiconductor die faces an active surface of the first semiconductor die; and
a second RDL structure coupled to the second semiconductor die.

2. The semiconductor package assembly as claimed in claim 1, wherein the first semiconductor package comprises more than one first semiconductor die and/or the second semiconductor package comprises more than one second semiconductor die.

3. The semiconductor package assembly as claimed in claim 1 or 2, further comprising a conductive structure, wherein the conductive structure is coupled to the first RDL structure and the second RDL structure.

4. The semiconductor package assembly as claimed in claim 3, further comprising an adhesive layer, wherein the adhesive layer is positioned between the first RDL structure and the second RDL structure and surrounds the conductive structure.

5. The semiconductor package assembly as claimed in one of the preceding claims, wherein the first semiconductor die and the second semiconductor die are of different sizes.

6. The semiconductor package assembly as claimed in one of the preceding claims, wherein the first semiconductor package further comprises a first molding compound, wherein the first molding compound surrounds sidewalls of the first semiconductor die.

7. The semiconductor package assembly as claimed in claim 6, wherein the first RDL structure covers the first molding compound.

8. The semiconductor package assembly as claimed in claim 6 or 7, wherein the first semiconductor package further comprises a via, wherein the via penetrates the first molding compound and is coupled to the first RDL structure.

9. The semiconductor package assembly as claimed in claim 8, further comprising a conductive component coupled to the via, wherein the first semiconductor die is positioned between the first RDL structure and the conductive component.

10. The semiconductor package assembly as claimed in one of the preceding claims, wherein the second semiconductor package further comprises a second molding compound, and the second molding compound surrounds sidewalls of the second semiconductor die,
wherein the second RDL structure covers the second molding compound, and/or
wherein the second semiconductor package further comprises a via, wherein the via penetrates the second molding compound and is coupled to the second RDL structure.

11. The semiconductor package assembly as claimed in claim 10, further comprising a conductive component coupled to the via, wherein the second semiconductor die is positioned between the second RDL structure and the conductive component.

12. The semiconductor package assembly of one of the preceding claims
wherein the first RDL structure is positioned between the first semiconductor die and the second RDL structure.

13. A method for forming a semiconductor package assembly, comprising:
forming a first semiconductor package, wherein the first semiconductor package comprises:
a first semiconductor die; and
a first redistribution layer (RDL) structure coupled to the first semiconductor die;
forming a second semiconductor package, wherein the second semiconductor package comprises:
a second semiconductor die, wherein an active surface of the second semiconductor die faces an active surface of the first semiconductor die; and
a second RDL structure coupled to the second semiconductor die; and
bonding the second semiconductor package to the first semiconductor package, wherein the first RDL structure is positioned between the first semiconductor die and the second RDL structure.

14. The method as claimed in claim 13, wherein the formation of the second semiconductor package comprises:
forming vias on a second carrier substrate;
bonding the second semiconductor die onto the second carrier substrate;
forming a second molding compound on the second carrier substrate, wherein the second molding compound surrounds the vias and sidewalls of the second semiconductor die, and wherein the second molding compound exposes top surfaces of the vias and the second semiconductor die; and
forming the second RDL structure on the second semiconductor die and the second molding compound.

15. The method as claimed in claim 13 or 14, wherein the formation of the first semiconductor package comprises:
bonding the first semiconductor die onto a first carrier substrate;
forming a first molding compound on the first carrier substrate, wherein the first molding compound surrounds sidewalls of the first semiconductor die and exposes a top surface of the first semiconductor die; and
forming the first RDL structure on the first semiconductor die and the first molding compound.
